Europäisches Patentamt

European Patent Office

Office européen des brevets

(19)

(11) Numéro de publication: **0 027 078**
**B1**

(12) **FASCICULE DE BREVET EUROPEEN**

(45) Date de publication du fascicule du brevet: **06.02.85**

(51) Int. Cl.⁴: **G 01 R 31/28, H 04 B 17/00**

(21) Numéro de dépôt: **80401384.5**

(22) Date de dépôt: **01.10.80**

(54) Dispositif de contrôle et de diagnostic pour auto-radios.

(30) Priorité: **02.10.79 FR 7924465**

(43) Date de publication de la demande:
**15.04.81 Bulletin 81/15**

(45) Mention de la délivrance du brevet:
**06.02.85 Bulletin 85/06**

(84) Etats contractants désignés:
**AT BE CH DE GB IT LI LU NL**

(56) Documents cités:
**US-A-3 467 867**

**TOUTE L'ELECTRONIQUE, vol. 37, no. 348, RT 198, septembre 1970, Paris, FR "Indicateur de niveau stéréophonique", page 340**
**NEWS FROM ROHDE & SCHWARZ, vol. 14, no. 67, 1974. München, DE T. FRÜHAUF; "Automatic test assembly for radio sets SMPU". pages 12-15**

**Le dossier contient des informations techniques présentées postérieurement au dépôt de la demande et ne figurant pas dans le présent fascicule.**

(73) Titulaire: **Rondier, Jacques**
**Lande Julien**
**F-29124 Riec-sur Belon (FR)**

(72) Inventeur: **Rondier, Jacques**
**Lande Julien**
**F-29124 Riec-sur Belon (FR)**

(56) Documents cités:
**JAPAN ELECTRONIC INDUSTRY, vol. 19, février 1972, nr. 2, Tokyo, JP "Fully automated car radio metering system drastically reduces the time required", pages 35-36**

Courier Press, Leamington Spa, England.

# Description

La présente invention est un dispositif destiné au contrôle et diagnostic de pannes de auto-radios, et lecteurs de cassettes incorporés ou non à l'auto-radio, monophoniques et stéréophoniques, et leurs accessoires périphériques tels qu'antenne, haut-parleurs câblage.

Une caractéristique essentielle du dispositif est son aptitude à effectuer les contrôle et diagnostic de pannes des appareils indiquées: aussi bien en atelier, que directement à bord des véhicules sans nécessité d'une alimentation.

L'invention est particulièrement destinée à l'usage des professionnels de l'automobile exploitant le marché de l'auto-radio, électriciens et mécaniciens de garages assurant un service auto-radio élémentaire.

Pour cette catégorie d'utilisateurs, il n'existe pas présentement d'appareil de service spécialisé, conçu á leur intention et à leur niveau de compétance, permettant de faire de façon simple, aisée, rapide ete précise, les contrôles et diagnostics de pannes de leur ressort.

Le document US—A—3 467 867 décrit un dispositif ayant une vocation de service auto-radio mais de conception et utilisation différentes. Ce dispositif est orienté vers des mesures concernant-essentiellement des caractéristiques d'antennes et leurs câbles. Il comporte un montage électronique, oscillateur à transistor, nécessitant une alimentation interne. Les prestations effectuées sont de la compétence d'un électronicien et non de celle d'un mécanicien ou électricien de garage. De plus, ce dispositif ignore la stéréophonie et le lecteur de cassettes. Il ne fournit pas l'alimentation basse tension nécessaire au fonctionnement d'un auto-radio, obligeant à une alimentation complémentaire.

Dans les garages et en l'état actuel des équipements existants, les habituelles prestations de service auto-radio s'effectuent généralement à l'aide d'accessoires disparates réunis pour l'occasion: alimentation de l'auto-radio à tester à l'aide d'une batterie ou d'un bloc secteur, antenne et haut-parleur volants, branchements souvent incertains pouvant présenter des risques pour les appareils en contrôle: inversion de polarité d'alimentation, débit sur sortie non chargée par exemple. Pour les appareils stéréophoniques, le contrôle du point d'équilibre des voies se fait approximativement à l'oreille à l'aide d'un signal musical, donc variable.

La présente invention a pour but de permettre aux utilisateurs précités d'effectuer leurs opérations de service auto-radio avec aisance, rapidité, précision: contrôle et diagnostic de pannes des auto-radios et lecteurs de cassettes, monophoniques et stéréophoniques, et leurs accessoires périphériques, avant leur pose ou en fonctionnement, en atelier ou directement à bore du véhicule.

Elle a pour objet un appareil tel que revendiqué dans la revendication I, simple, portatif, de faible encombrement, réunissant un ensemble de composants et montages connus dont la combinaison permet une application originale.

Elle se présente sous la ferme d'un coffret portatif contenant l'ensemble des éléments, objet de l'invention:

— Un block d'alimentation fonctionnant sur courant alternatif de ville et délivrant une basse tension continue, régulée ou non, conforme à la tension d'alimentation des auto-radios et lecteurs de cassettes. Ce sous-ensemble est autonome. Il est destiné à alimenter en atelier l'appareil à tester. Il n'est pas utilisé lors des prestations à bord des véhicules.

— Dérivée de l'alimentation base tension ci-dessus, une sortie basse tension auxiliaire, avec contrôle visuel.

— Une antenne avec son câble de reccordement.

— Un haut-parleur.

— Un circuit commuté, de contrôle séparé des voies des appareils stéréophoniques.

— Un circuit commuté, de contrôle d'équilibre des voies des appareils stéréophoniques, avec contrôle visuel

— Un circuit commuté, de contrôle de haut-parleurs.

— Un commutateur à quatre commandes, permettant les utilisations suivantes:
. contrôle de voie gauche seule d'un appareil stéréophonique.
. contrôle de voie droite seule d'un appareil stéréophonique.
. contrôle d'un haut-parleur.
. contrôle d'équilibre des voies d'un appareil stéréophonique.

— Une bande magnétique en cassette, sur laquelle est, enregistré signal test.

— Un jeu de câbles de raccordement, équipés de connecteurs normalisés pour le présent appareil et la majorité des auto-radios.

Ces différents éléments composent deux sous-ensembles, électriquement indépendants l'un de l'autre: une partie "alimentation", une partie "contrôle".

Lar partie "contrôle", autonome, peut être utilisée seule à bord d'un véhicule, l'auto-radio testé restant branché à la batterie de bord pour son alimentation. Cette conception est particulièrement intéressante pour certains diagnostics de pannes, ainsi effectués sans dépose complète de l'installation. Le dessin annexé illustre à titre d'exemple un mode de réalisation du dispositif conforme à la présente invention et qui permet entre autres les tests suivants: En atelier, à l'aide des câbles prévus à cet effet, raccorder: la ou les sorties haut-parleurs de l'auto-radio, à la prise A pour un appareil mono, aux prises A et B pour un appareil stéréo, l'antenne C et la basse tension D aux prises correspondantes de l'auto-radio. Positionner les commutateurs: E sur EI, F sur FI, G sur GI. Connecter l'entrée du bloc d'alimentation au courant alternatif de ville. Sur véhicule, l'auto-radio à contrôler reste raccordé à la batterie de bord pour son alimentation et le dispositif n'est pas relié au courant alternatif de ville. Tous les autres raccordements et commutations restent comme ci-dessus.

L'ensemble étant en fonctionnement, les différentes fonctions de l'appareil en contrôle peuvent être testées, en réception radio, ainsi qu'en lecteur de cassettes à l'aide, soit de la cassette-test, soit d'une cassette musicale du commerce.

Pour un appareil stéréophonique, la manoeuvre du commutateur G sur GI puis sur G2 commute le haut-parleur interne du dispositif successivement sur chacune des deux voies de l'appareil testé. Cette technique originale, qui permet ainsi de tester chaque voie séparément, est plus précise que le montage usuel à deux haut-parleurs par lequel les deux voies sont entendues simultanément et confondues. Il est alors difficile, voire impossible de discerner d'éventuelles différences ou anomalies d'une voie par rapport à l'autre, différences qui, même légères, apparaissent nettement avec le dispositif objet de l'invention, du fait du caractère instantané de la commutation.

Pour un lecteur de cassettes stéréophonique, le contrôle précis d'équilibre, ou de balance, des deux voies s'effectue en faisant lire au lecteur la cassette-test. L'appareil à tester étant raccordé comme décrit ci-dessus, positionner le commutateur E sur E2. Cette manoeuvre substitue au haut-parleur interne du dispositif un circuit qui intègre les signaux en phase émanant des deux voies de l'appareil stéréo. Le signal résultant est visualisé sur un galvanomètre, ou tout autre indicateur visuel.

La manoeuvre de la commande de balance de l'appareil testé permet de déterminer le point d'égalité de signal sur les deux voies, ce point correspondant à la déviation maximale du galvanomètre, ou à l'indication de maximum de tout autre indicateur visuel.

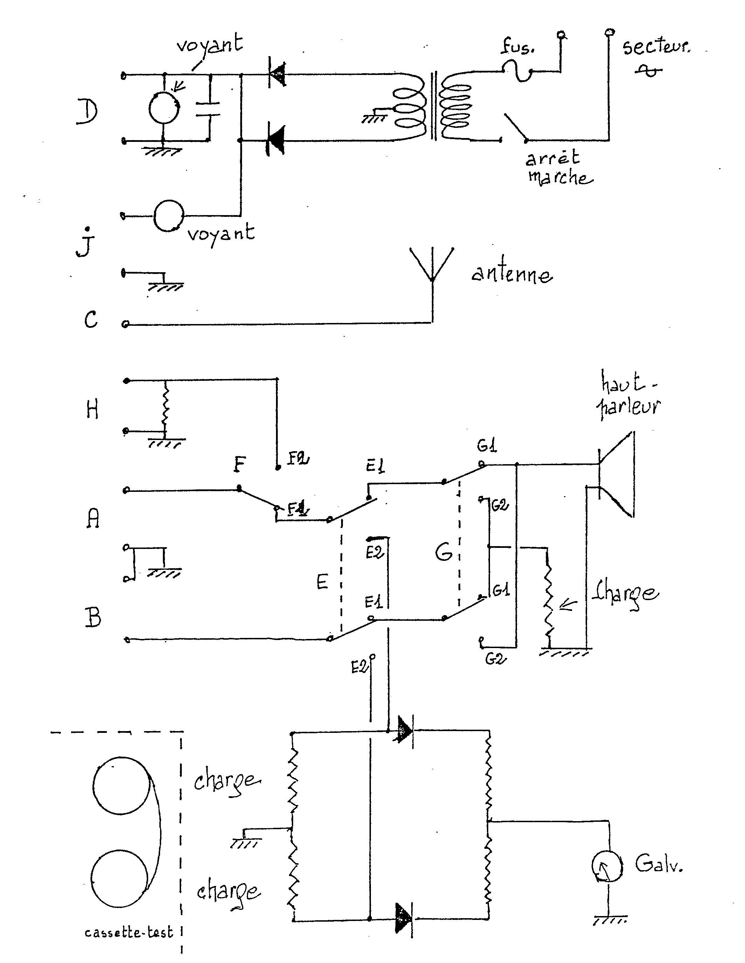

La cassette-test permet également de mettre en évidence des anomalies d'entraînement de bande set traduisant, soit par un son ondulé dans le haut-parleur du dispositif en position EI, soit par un maximum instable de l'aiguille du galvanomètre en position E2. Ce système de contrôle d'équilibre des deux voies d'un amplificateur stéréophonique est similaire à celui décrit dans la revue "Toute l'Electronique" de septembre 1970, page 340, figure 2. Toutefois, la présente invention n'utilise pas de transistor, augmentant de ce fait la fiabilité du dispositif suivant l'invention. Le montage Schody décrit dans le même article fait appel à une technique différente utilisant un déphaseur, l'égalité de signal étant indiquée par un minimum sur le galvanomètre.

Le contrôle d'un haut-parleur s'effectue en le raccordant à la prise H du dispositif et en le substituant au haut-parleur interne de celui-ci par la commutation de F sur F2, un auto-radio étant raccordé et en fonctionnement sur le dispositif. La manoeuvre répétée de F, sur FI puis F2 permet de faire rapidement un test comparatif: haut-parleur interne du dispositif/haut-parleur en essai.

La prise basse tension auxiliaire J a deux utilisations:

— le repérage de polarité des haut-parleurs, pour les installations stéréophoniques.
— le contrôle de coupure ou de continuité de composants divers, la continuité et le court-circuit étant indiqués par l'allumage d'un voyant, en série dans le circuit.

Les deux circuits d'entrée du sous-ensemble "contrôle" peuvent avoir, soit une masse commune, soit des masses respectivement isolées. Cette seconde formule est nécessaire dans le cas de contrôle d'appareils stéréophoniques de forte puissance, de type booster par exemple, dont les conducteurs de sorties n'ont pas de point commun.

Les diagnostics de pannes s'effectuent, en atelier ou directement à bord du véhicule, par des tests comme ceux précédemment décrits ou la substitution d'éléments du dispositif à ceux de l'installation testée.

**Revendications**

1. Dispositif destiné au contrôle et diagnostic de pannes des auto-radios avec leurs accessoires périphériques tels qu'antenne, haut-parleurs et câblage, ledit dispositif comprenant, réunis en un coffret portatif, l'ensemble des composants, montages et éléments de raccordement nécessaire auxdits contrôle et diagnostic de pannes, ceux-ci pouvant être effectués aussi bien en atelier que directement à bord du véhicule; ledit dispositif étant caractérisé par le fait qu'il est aussi destiné au contrôle et diagnostic de pannes des lecteurs de cassettes, incorporés ou non aux auto-radios, lesdits auto-radios et lecteurs de cassettes pouvant être des appareils monophoniques ou stéréophoniques; par le fait que ledit dispositif est subdivisé en deux sous-ensembles: d'alimentation, pour l'alimentation externe desdits appareils, et de contrôle, pour le contrôle et diagnostic de pannes desdits appareils, lesdits sous-ensembles étant indépendants l'un de l'autre et pouvant être utilisés séparément; par le fait que le sous-ensemble d'alimentation convertit le courant alternatif de ville en une basse tension continue (D) nécessaire au fonctionnement en atelier desdits appareils, cette basse tension étant également disponible sur une sortie auxiliaire (J) avec voyant lumineux en série, destinée au repérage de polarité des haut-parleurs et à divers tests secondaires: et par le fait que le sous-ensemble de contrôle comprend: deux prises d'entrée (A, B) à raccorder aux sorties respectives des haut-parleurs de l'auto-radio lorsque celui-ci est stéréophonique, l'une (A) d'entre elles étant à raccorder à la sortie du haut-parleur de l'auto-radio lorsque celui-ci est monophonique, une cassette-test, une antenne avec son câble de raccordement (C), un haut-parleur, un circuit commuté (G) de contrôle séparé des voies desdits appareils stéréophoniques, un circuit commuté (E) de contrôle d'équilibre des voies desdits appareils stéréophoniques avec contrôle sur galvanomètre ou tout autre indicateur visuel, et un circuit commuté (F) d'essai de haut-parleurs, ledit sous-ensemble de contrôle ne nécessitant pour son fonctionnement ni alimentation, ni batterie interne ni raccordement au courant alternatif de ville.

2. Dispositif selon la revendication I caractérisé par le fait que la cassette-test est une bande magnétique sur laquelle sont enregistrés en double piste deux signaux de fréquence fixe audible, d'amplitudes égales, invariables et en phase sur les deux pistes.

3. Dispositif selon la revendication I caractérisé par le fait que les deux circuits du sous-ensemble de controle reliés aux deux prises (A, B) d'entrée du dispositif peuvent comporter une masse commune ou ne comporter aucun point commun.

## Patentansprüche

1. Vorrichtung für die Kontrolle und Ermittlung von Pannen bei Autoradios und ihren Zubehörteilen wie Antenne, Lautsprecher und Verkabelung, wobei die genannte Vorrichtung in einem tragbaren Kasten die gesamten Bestandteile, Schaltungen und Anschlusselemente umfasst, die für die genannte Kontrolle und Ermittlung von Pannen notwendig sind, die sowohl in der Werkstatt als auch direkt im Fahrzeug erfolgen kann; die genannte Vorrichtung ist dadurch gekennzeichnet, dass sie ebenfalls für die Kontrolle und die Ermittlung von Pannen bei Kasettenrecordern bestimmt ist, die im Autoradio eingebaut oder nicht sind, wobei die gennanten Autoradios und Kassettenrecorder Mono- und Stereogeräte sein können; dadurch gekennzeichnet, dass die genannte Vorrichtung in zwei Untergruppen eingeteilt ist: eine für die Speisung, also für die Aussenversorgung der genannten Geräte und eine für die Kontrolle und Ermittlung von Pannen der besagten Geräte, wobei die genannten Untergruppen voneinander unabhängig sind und getrennt benutzt werden können; dadurch gekennzeichnet, dass die Versorgungsuntergruppe den Wechselstrom des städtischen E-Netzes in eine niedrige Gleichspannung (D) umwandelt, die für die Funktion der genannten Geräte in der Werkstatt notwendig ist und die ebenfalls auf einem Hilfsausgang (J) mit einer Serien-Kontrollampe verfügbar ist, der für die Polaritätskennzeichnung der Lautsprecher und für verschiedene, sekundäre Prüfungen bestimmt ist; und dadurch gekennzeichnet, dass die Kontroll-Untergruppe umfasst: zwei Eingangsstecker (A, B), die an die jeweiligen Ausgänge der Lautsprecher des Autoradios oder Kassettenrecorders angeschlossen werden, wenn diese stereofon sind oder von denen einer am Ausgang des Lautsprechers des Autoradios oder Kasettenrecorders anzuschliessen ist, wenn dieser monofon ist; eine Testkasette; eine Antenne mit ihrem Anschlusskabel (C); einen Lautsprecher; eine umgeschaltete Leitung (G) für eine von den Kanälen der genannten Stereogeräte getrennte Kontrolle; eine umgeschaltete Leitung (E) für die Kanalgleichgewichtskontrolle der genannten Stereogeräte mit Kontrolle auf Galvanometer oder jedem anderen Sichtanzeiger; und eine geschaltete Leitung (F) für die Prüfung der Lautsprecher, wobei die genannte Kontroll-Untergruppe für ihre Funktion weder eine Versorgung noch eine eingeschlossene Batterie oder einen Anschluss an das städtische Wechselstromnetz erfordert.

2. Vorrichtung gemäss Anspruch I dadurch gekennzeichnet, dass die Testkassette ein Magnetband ist, auf dem doppelspurig zwei festliegende und hörbare Frequenzsignale von gleicher Amplitude, unveränderbar und in Phase auf den beiden Spuren aufgenommen sind.

3. Vorrichtung gemäss Anspruch I dadurch gekennzeichnet, dass die beiden Leitungen der Kontroll-Untergruppen, die an den beiden Eingangssteckern (A, B) der Vorrichtung angeschlossen sind, eine gemeinsame Masse oder keinerlei gemeinsamen Punkt aufweisen können.

## Claims

1. System designed for testing and troubleshooting automobile radios with their peripheral accessories such an antenna, loudspeakers and wiring, said system including, in a portable unit, all the components, circuits and connecting parts required for said testing and troubleshooting, which can be carried out both in the repair shop and directly on the vehicle; said system being characterized by the fact that it is also designed for testing and troubleshooting cassette readers, included or not in automobile radios, said automobile radios and cassette readers being either monophonic or stereophonic; by the fact that said system is divided in two subsystems: power supply, for external power supply of said appliances and tester for testing and troubleshooting of said appliances, said subsystems being independent of one another and suitable for use separately; by the fact that the power supply subsystem converts the AC line power to a DC low voltage (D) required for operation in the repair shop of said appliances, said low voltage being also available on an auxiliary output (J) with series indicator light designed for identifying the polarity of the loudspeakers and for various secondary tests: and by the fact that said test subsystem includes: two input connectors (A, B) for connection to the respective outputs of the automobile radio or cassette reader loudspeakers when stereophonic, one (A) for connection to the output of the automobile radio or cassette reader loudspeaker when monophonic; a test cassette; an antenna with connecting cable (C); a loudspeaker; a switched circuit (G) for separate test of the channels of said stereophonic appliances; a switched circuit (E) for testing the balance between the channels of said stereophonic appliances with monitoring on a meter of any other visual indicator; and a switched circuit (F) for testing of the loudspeakers, said test subsystem not requiring a power supply unit, an internal battery nor connection to AC line power for operation.

2. System as per claim 1 characterized by the fact that the test cassette is a magnetic tape on which are recorded on dual track two fixed audio frequency signals equal in amplitude, invariable and in phase on the two tracks.

3. System as per claim 1 characterized by the fact that the two circuits of the test subassembly, connected to input connectors (A, B) of the system may include a common ground or no common point.